# EUROPEAN PATENT SPECIFICATION

(11) **EP 2 886 678 B1**
(45) Date of publication and mention of the grant of the patent: **09.11.2016**
(21) Application number: 14199052.3
(22) Date of filing: 18.12.2014
(51) Int. Cl.: C23C 14/54, C23C 14/30, C23C 14/08, C23C 14/58, H01M 8/1213, H01M 8/1246, H01M 4/88, H01M 4/90, H01M 8/124

(54) **Method for the deposition of films of mixed oxides on composite material substrates**
Verfahren zur Abscheidung von Mischoxiden auf Verbundmaterial-Substraten
Méthode de déposition de films d'oxydes mixtes sur des substrats en matériau composite

(30) Priority: 18.12.2013 IT MI20132125
(43) Date of publication of application: 24.06.2015
(73) Proprietor: EDISON S.p.A., 20121 Milano (IT)
(72) Inventor: Bindi, Massimiliano, 10042 NICHELINO (IT)
(74) Representative: Cernuzzi, Daniele

(56) References cited:
- EP-A1- 2 036 999
- WO-A1-2008/119321
- WO-A2-2006/107865
- DE-C1- 19 715 791
- US-A- 6 153 271
- US-B1- 7 123 416

## Description

The present invention concerns a method for the deposition of films of mixed oxides on composite material substrates.

In particular, the invention concerns a method for the deposition of films of mixed oxides on composite material substrates for the growth of thin electrolytic or cathodic layers for solid oxide fuel cells (SOFC), where the films of mixed oxides are deposited on metal/oxide or oxidel/oxide2 substrates, the latter already covered if necessary with an electrolytic layer.

In greater detail, the invention refers to the formation, on said composite substrates typically having the function of anode electrode, of a thin layer having the function of electrolyte or, if the thin layer is deposited on an electrolyte, of cathode electrode.

Fuel cells based on membranes of solid oxides (SOFC) constitute highly efficient eco-compatible systems for the generation of electrical energy. However, their use on a medium and large scale has so far been impeded by generally high costs and problems with performance, which occur above all in configurations where cost limitation is sought.

The greatest difficulties encountered in developing efficient SOFCs concern the requirements to be met by the electrolytic layer which:
- must have a high density;
- must have a uniform chemical composition in order to have good ionic conduction at operating temperatures;
- must be thin to reduce the ionic resistance;
- must be extensive in order to maximise the current density;
- must be resistant to thermal shocks.

The current techniques used at industrial level to produce these layers (for example pressing and annealing of very fine powders, screen-printing, tape-casting and others) do not allow the manufacture of sufficiently fine layers extending over vast areas, and this has induced the international scientific community to investigate the effectiveness of advanced physical technologies (Physical Vapour Deposition, PVD) for the deposition of thin films (thicknesses lower than or in the order of 10 µm) of the various active components of the SOFCs.

Another critical aspect for the development of good SOFCs is the operating temperature: ideally it is desirable to obtain cells that can operate at temperatures much lower than the current 850-1000°C. A reduction in the operating temperatures would also allow, among other things, the use of low cost metal interconnection materials compared to those currently required, and the use of simpler gas supporting and retaining structures for the cell stacks.

In short, the development of SOFCs requires the identification of appropriate and particular electrolytic ceramic materials and the consequent set-up of reliable procedures for the deposition of said materials in the form of thin films.

One object of the present invention is to provide a method for the deposition of a mixed oxide film able to meet the above-mentioned requirements.

Said object is achieved by the present invention, since it concerns a method according to claim 1.

The method of the invention is, as a whole, particularly simple and reliable and allows, above all, perfectly functional thin electrolytic or cathodic films to be obtained, for example, for use within a SOFC.

Furthermore, the equipment necessary for implementing the method according to the present invention is relatively simpler and cheaper than that required for other vacuum deposition techniques. The deposition technique by means of electron gun has proved to be surprisingly flexible and very suited to said application.

The invention is further described in the following non-limiting implementation examples, with reference to the accompanying figures in which:
- figure 1 is an X ray diffractogram of a thin film of mixed oxide obtained according to the method of the present invention, and
- figure 2 is a SEM micrograph of a section of a mixed oxide film of zirconium and yttrium represented by the formula (Y₂O₃)_{0.08}(ZrO₂)_{0.92} (8-YSZ), obtained according to the method of the present invention.

The present invention concerns a method for the deposition of a film of mixed oxide on a composite material substrate (composite substrate).

In particular, the film of mixed oxide deposited on the substrate constitutes a thin electrolytic layer of a SOFC, and the substrate is an anodic composite substrate of said SOFC.

The substrate is preferably a planar substrate, for example of circular or polygonal shape and in any case preferably already shaped for the final application, of a composite material typically used as anode in SOFCs. In particular, the substrate consists of a metal/oxide, oxide1/oxide2 composite material, or one of the latter already covered with an electrolytic layer for SOFCs.

For example, the substrate is made of a composite material of grains of nickel oxide and grains of an oxide of transition elements, even the same as the mixed oxide to deposit. The substrate is characterised by a certain degree of porosity and surface roughness.

The mixed oxide with which the film is produced on the substrate is preferably selected from the group consisting of: BaCe_{0.9}Y_{0.1}O_{3-d} (BCY-10), BaCe_{0.8}Y₀.₂O_{3-d} (BCY-20), (La_{0.8}Sr_{0.2}) _{0.95}CoO_{3-d} (LSC), (Y₂O₃)_{0.06} (ZrO₂)_{0.92} (8-YSZ), Gd_{0.1}Ce_{0.9}O₂-_{d} (10-GDC), Gd_{0.2}Ce_{0.8}O_{2-d} (20-GDC), Sm_{0.15}Ce_{0.85}O_{2-d} (15-SDC), Sm_{0.2}Ce_{0.8}O_{2-d} (20-SDC), (Sc₂O₃)_{0.1} (ZrO₂)_{0.9} (10-ScSZ), Ba (CeₓZr₁₋ₓ)_{0.9}Y_{0.1}O_{3-d} (BZY-10), Ba₂In_{1.8}Ti_{0.2}O_{5+d} (BIT-02), BaIn_{0.3}Ti_{0.7}O_{3-d} (BIT-07), Nd₂NiO_{4+δ}, Pr₂NiO_{4+δ}. Er_{0.4}Bi_{1.6}O₃ (ESB), Dy_{0.08}W_{0.04}Bi_{0.88}O_{1.56} (DWSB).

In particular, the substrate has (data from surface analysis by atomic force microscopy - AFM) the following characteristics:
- in an area of 50µm x 50µm:
   - maximum height of grains: <4500 nm;
   - mean surface roughness: <600 nm;
- in said area, enlarged to 6µm x 6µm:
   - maximum height of grains: <1800 nm;
   - mean surface roughness: <300 nm;
- in said area (6µm x 6µm), further enlarged to 800nm x 800nm:
   - maximum height of grains: <400 nm;
   - mean surface roughness: <70 nm;
- size of pores: less than 600 nm.

In general, the method of the invention comprises:
- a step of providing in a deposition chamber, in which a vacuum can be created, for example by means of a vacuum pump: a substrate made of composite material on which a film of mixed oxide is to be deposited; and a target of mixed oxide made of a material having the same stoichiometric composition as the film to deposit;
- an evaporation-deposition step of the target material (mixed oxide), in which the target is bombarded, by means of an electron gun (EB-PVD technique), with an electron beam of a certain power so as to cause the evaporation of material from the target and deposition of the evaporated material on the substrate to form an oxide film;
- a step of *in situ* heat treatment and annealing of the film of mixed oxide, to further densify the thin film obtained and/or to guarantee the right oxygen content in the thin film.

The target is for example in the form of solid densified pellets, placed in a crucible (evaporation source) positioned opposite the electron gun in the deposition chamber. Preferably, the pellets are made of the mixed oxide with purity of at least 99.00%.

In the evaporation-deposition step by means of electron beam, the mixed oxide is evaporated under a high vacuum and is deposited on the substrate in a quantity sufficient to guarantee substantial uniformity in terms of composition and thickness of the film.

Preferably, the evaporation-deposition step in turn comprises the steps of:
- reducing the pressure within the deposition chamber to below 10⁻⁴ mbar;
- heating the substrate to a temperature in the range between 300°C and 800°C;
- activating the electron gun so as to evaporate and deposit a film of mixed oxide on the substrate, obtaining a pre-treated substrate.

Preferably, the substrate is heated to a temperature in the range between 450 and 750°C, more preferably to a temperature of around 700°C.

Obtaining of an adequate uniformity in terms of composition can be further regulated by modifying the distance between the target and the substrate, taking into account that an increase in said distance promotes uniformity at the expense of less efficient exploitation of the target material, a part of which deposits on the walls of the deposition chamber.

Clearly, when operating with electron guns with incorporated crucible, the contents have to be re-established over time, and this can be easily obtained by providing, within the deposition chamber, tanks and vibration conveyors or other types of conveyors for the transport of new material.

In practice, when the substrate has been heated to the desired temperature, the electron gun is activated causing an appropriate electric current to flow through a tungsten filament. By applying an appropriate potential difference between the above-mentioned filament and an earthed metal part in the vicinity thereof, the electron beam is extracted. Appropriate magnetic fields deflect the electron beam, causing it to impact on the target of mixed oxide, thus causing the heating and evaporation thereof. It is clear that the material of the crucible, containing the solid densified starting pellets of mixed oxide, must be chemically inert vis-à-vis the material to evaporate and deposit.

According to the invention, the evaporation-deposition step is carried out at an increasing deposition rate, measured on the substrate; in particular, the evaporation-deposition step comprises at least one first step of growth carried out at a deposition rate (measured on the substrate) lower than or equal to a predetermined threshold, and at least one second step of growth carried out at a deposition rate greater than said threshold. Said first step of growth, carried out at a deposition rate lower than or equal to the predetermined threshold, has the purpose of lowering the surface roughness and porosity level of the substrate and thus preparing the substrate for a homogeneous growth of the film of mixed oxide, during the following steps of growth.

In particular, the threshold is 0.03 nm/sec.

The increase in the deposition rate can be obtained in different ways, in particular by means of discrete or progressive increments or combinations of progressive increments and discrete increments.

For example, the evaporation-deposition step comprises:
- two or more steps of growth in which the deposition rate is constant, and the deposition rate increases from at least one step of growth to the next; and/or
- at least one step of growth in which the deposition rate increases gradually; and/or
- a plurality of steps of growth in some of which the deposition rate is maintained constant, and in others it increases, optionally increasing in a different manner in respective steps of growth;
- different combinations of steps of growth in which the deposition rate is constant, increases at a constant gradient, increases at a different gradient in different steps of growth.

The number of steps of growth necessary is selected as a function of the desired final thickness of the film of mixed oxide.

To control the deposition rate, a feedback control system can be provided based on monitoring, for example by means of oscillating crystals, the thickness of the layer deposited on the substrate. It should be noted that the evaporation rate of the metal species is proportional to the density of the vapour and to the speed of propagation of the atoms in the vapour which in turn depend substantially on the temperature of the evaporative source. Said parameters can be controlled by adjusting the power of the electron gun, and therefore the values of the electric current emitted and the electric extraction/acceleration voltage of the electron beam produced. It is therefore possible to appropriately calibrate, over time, the evaporation rate and therefore the deposition rate and, consequently, the thickness of material which is deposited on the substrate.

Using appropriate control instruments for controlling the power of the electron gun, it is possible to automatically set power profiles over time (and therefore vary the deposition speed).

The evaporation-deposition step is carried out for a time sufficient to form, on the substrate to cover, a surface layer of the desired thickness. It is furthermore possible to provide insertion of a flow of process gas from the outside, for example oxygen, such that the pressure in the deposition chamber does not increase beyond 2x10⁻⁴ mbar.

Two preferred embodiments of the method of the invention are described below, purely by way of non-limiting example. The two embodiments described differ in the evaporation-deposition step, more precisely at the rate at which the film of mixed oxide is deposited.

In a first embodiment, given the state of porosity and surface roughness of the composite anode substrates typically used in SOFCs, to obtain compact homogeneous layers of mixed oxides with thickness greater than 1.5 µm, the evaporation-deposition step comprises four steps of growth, in each of which the deposition rate is maintained constant for a predetermined time ranging from approximately 60 to approximately 90 minutes. The deposition rate in each step of growth is greater than or equal to the deposition rate of the previous step of growth and lower than or equal to the deposition rate of the following step of growth, and the deposition rate increases between at least one step of growth and the next.

In particular, the evaporation-deposition step comprises:
- a first step of growth with deposition rate constant in the range between 0.01 and 0.03 nm/sec;
- a second step of growth with deposition rate constant in the range between 0.01 and 0.03 nm/sec;
- a third step of growth with deposition rate constant in the range between 0.04 and 0.06 nm/sec;
- a fourth step of growth with deposition rate constant in the range between 0.09 and 0.11 nm/sec.

To obtain compact homogeneous layers of mixed oxides having thickness less than or equal to 1.0 µm, the evaporation-deposition step comprises a first and a second step of growth, in each of which the deposition rate is maintained constant for a predetermined time in the range between approximately 60 and approximately 90 minutes. The deposition rate is constant in the range between 0.01 and 0.03 nm/sec in the first step of growth; and it is constant in the range between 0.09 and 0.15 nm/sec in the second step of growth.

In both cases, the first step of growth is carried out at a deposition rate no higher than 0.03 nm/sec.

In general, according to the desired final thickness of the film, the number of steps of growth necessary are set each time, where the first step of growth is characterised by a deposition rate on the substrate no higher than 0.03 nm/sec.

In a second embodiment, to obtain on the substrate a compact homogeneous film of mixed oxide with thickness greater than 1.5 µm, the evaporation-deposition step comprises four steps of growth, in each of which the evaporation-deposition rate is maintained constant for a predetermined time ranging between approximately 10 and 15 minutes. The deposition rate in each step of growth is greater than or equal to the deposition rate of the previous step of growth and lower than or equal to the deposition rate of the following step of growth, and the deposition rate increases between at least one step of growth and the next.

In particular, the evaporation-deposition step comprises:
- a first step of growth with deposition rate constant in the range between 0.01 and 0.03 nm/sec;
- a second step of growth with deposition rate constant in the range between 0.2 and 0.4 nm/sec;
- a third step of growth with deposition rate constant in the range between 0.7 and 1.0 nm/sec;
- a fourth step of growth with deposition rate constant in the range between 1.6 and 2.0 nm/sec.

To obtain compact homogeneous layers with thickness less than or equal to 1.0 µm, the evaporation-deposition step comprises two steps of growth, during each of which the deposition rate is maintained constant for a time ranging from approximately 10 to 15 minutes. The deposition rate is constant in the range between 0.01 and 0.03 nm/sec in the first step of growth; and it is constant in the range between 2.0 and 2.5 nm/sec in the second (following) step of growth.

In general, according to the desired final thickness of the film, the number of steps of growth necessary are set each time, where the first step of growth is characterised by a deposition rate on the substrate no higher than 0.03 nm/sec.

In all the embodiments, the evaporation-deposition step comprises optionally and advantageously, between two successive steps of growth, a step of re-establishment of the target, in which the mixed oxide material of the target is re-established (i.e. the crucible - the evaporation source - is re-supplied with pellets of mixed oxide).

In all the embodiments of the invention, the evaporation-deposition step is followed by the step of heat treatment and annealing which, preferably, is carried out *in situ,* in the same deposition chamber in which the evaporation-deposition step takes place, in an inert atmosphere (for example of argon or nitrogen), or in an oxidising atmosphere (for example in pure oxygen).

For example, the *in situ* heat treatment and annealing step comprises in turn the steps of: bringing the temperature of the pre-treated substrate to a temperature in the range between 500°C and 800°C, at the same time introducing a gas flow into the deposition chamber, at least in the vicinity of the substrate, until reaching in the deposition chamber a partial pressure in the range between 200 mbar and 1000 mbar; and then maintaining constant pressure and temperature in the deposition chamber for a time ranging from approximately 30 to 60 minutes.

In practice, once transfer of the mixed oxide onto the substrate has been completed, the vacuum pump and the electron gun are switched off.

While the step of heat treatment and annealing of the film of mixed oxide is carried out *in situ* (without needing to open the deposition chamber), the temperature values of the substrate and the (partial) pressure values of the treatment gas in the deposition chamber, once adjusted, are maintained substantially constant for a time ranging from approximately 30 to 60 minutes.

Preferably, the pre-treated substrate obtained from the evaporation-deposition step is brought to a temperature in the range between 650 and 750°C, more preferably to a temperature of around 700°C.

The final pressure of the treatment gas within the deposition chamber is preferably in the range between 500 and 1000 mbar.

The invention is further described in the following non-limiting implementation examples.

### EXAMPLE 1

The electron gun crucible was filled with 4 grams of pellets of sintered material (Y2O3) 0.08 (ZrO2)₀.₉₂ (8-YSZ), having dimensions: diameter 2 mm, height 5 mm.

An NiO/8-YSZ planar composite substrate was provided with diameter of 80 mm and thickness of 0.3 mm.

The substrate was arranged in a deposition chamber in which the pressure was brought to approximately 2.0x10⁻⁵ mbar, below a heating device arranged at a height of approximately 25 cm above the electron gun crucible.

The deposition rate of 8-YSZ was kept under control by adjusting the power of the electron beam, in four steps of growth of 90 minutes each, according to the following values, measured on the substrate:
- step 1): 0.02 nm/sec;
- step 2): 0.02 nm/sec;
- step 3): 0.1 nm/sec;
- step 4): 0.1 nm/sec.

During the first two steps of growth, no flow of gas was sent to the deposition chamber from the outside, whereas during the third and fourth step of growth, a flow of oxygen was sent so that the pressure inside the deposition chamber was approximately 10⁻⁴ mbar constant.

The following operating parameters were used:
- substrate temperature: 700°C
- deposition time: 90 min/step

The following operating parameters were used for the heat treatment and annealing step:
- substrate temperature: 700°C
- oxygen pressure: 500 mbar
- annealing time: 60 min

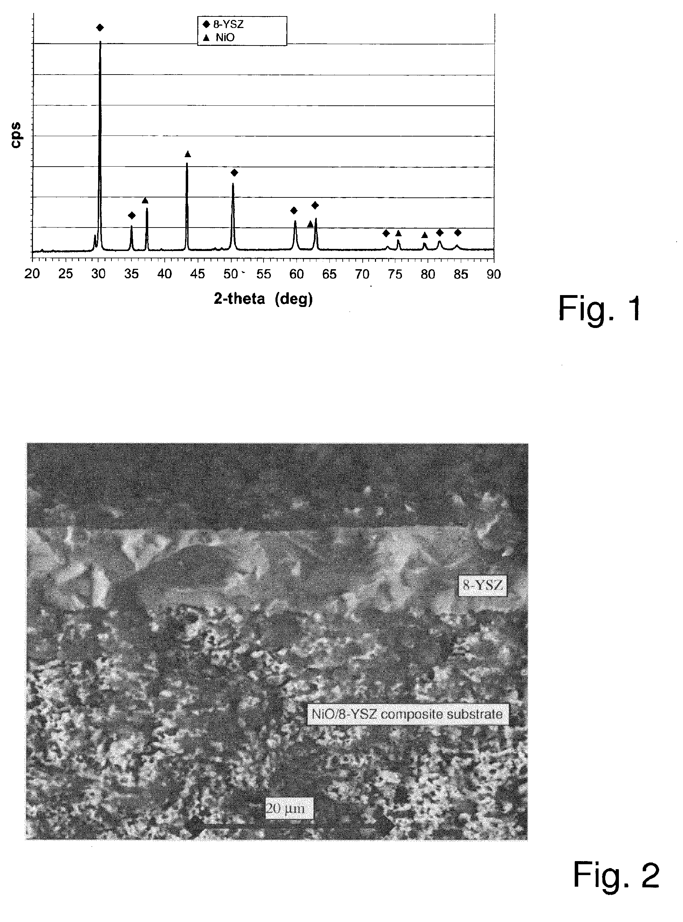

On the sample produced according to the methods described above, structural analyses were carried out using X-ray diffractometry directly on the thin film deposited (figure 1). Analyses performed using the scanning electron microscope revealed (figure 2) a high degree of compactness, particularly suitable for the electrolytic function scheduled within a SOFC.

### FURTHER EXAMPLES

Using methods analogous to those described previously, samples of 20-GDC and BCY-20 were prepared.

Equally satisfactory results were obtained, both in terms of compositional purity obtained and in terms of compactness of the covering layer.

Further samples were prepared, varying the procedure for carrying out the method of the invention according to the preceding description, always obtaining satisfactory results.

Lastly it is understood that further modifications and variations that do not depart from the scope of the attached claims can be made to the method for the deposition of films of mixed oxide on composite material substrates described and illustrated here.

## Claims

1. A method for the deposition of a film of mixed oxide on a composite material substrate, comprising an evaporation-deposition step of a mixed oxide, in which an electron beam is sent onto a target of mixed oxide having the same stoichiometric composition as the film to deposit, so as to cause evaporation of material from the target and deposition of evaporated material onto a substrate made of composite material; the method being **characterized in that** the evaporation-deposition step is carried out with a deposition rate, measured on the substrate, increasing during said evaporation-deposition step.

2. A method according to claim 1, wherein said evaporation-deposition step comprises at least one first step of growth carried out with a deposition rate lower than or equal to a predetermined threshold, and at least one second step of growth carried out with a deposition rate greater than said threshold, said threshold being in particular 0.03 nm/sec.

3. A method according to claim 1 or 2, wherein the evaporation-deposition step comprises two or more steps of growth in which the deposition rate is constant, and the deposition rate increases from at least one step of growth to the next.

4. A method according to one of the preceding claims, wherein the evaporation-deposition step comprises at least one step of growth in which the deposition rate increases gradually.

5. A method according to one of the preceding claims, wherein in each step of growth the deposition rate is maintained constant, or increases, optionally increasing in a different manner in respective steps of growth.

6. A method according to one of the preceding claims, comprising a step of selecting the necessary number of steps of growth as a function of the desired final thickness of the film of mixed oxide.

7. A method according to one of claims 1 to 6, wherein, for obtaining on the substrate a compact and homogeneous film of mixed oxide having a thickness greater than 1.5 µm, the evaporation-deposition step comprises at least four steps of growth, in each of which the deposition rate is maintained constant for a predetermined time ranging between 60 and 90 minutes; and wherein the deposition rate in each step of growth is greater than or equal to the deposition rate in the previous step of growth and lower than or equal to the deposition rate in the following step of growth, and the deposition rate increases between at least one step of growth and the next.

8. A method according to claim 7, wherein the evaporation-deposition step comprises:
- a first step of growth with a deposition rate constant in the range between 0.01 and 0.03 nm/sec;
- a second step of growth with a deposition rate constant in the range between 0.01 and 0.03 nm/sec;
- a third step of growth with a deposition rate constant in the range between 0.04 and 0.06 nm/sec;
- a fourth step of growth with a deposition rate constant in the range between 0.09 and 0.11 nm/sec.

9. A method according to one of the claims from 1 to 6, wherein, for obtaining on the substrate a compact and homogeneous film of mixed oxide having a thickness lower than or equal to 1.0 µm, the evaporation-deposition step comprises a first and a second step of growth, in each of which the deposition rate is maintained constant for a predetermined time ranging between 60 and 90 minutes; and wherein the deposition rate is constant in the range between 0.01 and 0.03 nm/sec in the first step of growth; and is constant in the range between 0.09 e 0.15 nm/sec in the second step of growth.

10. A method according to one of the claims from 7 to 9, wherein the first step of growth is carried out with a deposition rate no lower than 0.01 nm/sec.

11. A method according to one of the claims from 1 to 6, wherein, for obtaining on the substrate a compact and homogeneous film of mixed oxide having a thickness greater than 1.5 µm, the evaporation-deposition step comprises four steps of growth, in each of which the evaporation-deposition rate is maintained constant for a predetermined time ranging between 10 and 15 minutes; and wherein the deposition rate in each step of growth is greater than or equal to the deposition rate in the previous step of growth and lower than or equal to the deposition rate in the following step of growth; and the deposition rate increases between at least one step of growth and the next.

12. A method according to claim 11, wherein the evaporation-deposition step comprises:
- a first step of growth with a deposition rate constant in the range between 0.01 and 0.03 nm/sec;
- a second step of growth with a deposition rate constant in the range between 0.2 and 0.4 nm/sec;
- a third step of growth with a deposition rate constant in the range between 0.7 and 1.0 nm/sec;
- a fourth step of growth with a deposition rate constant in the range between 1.6 and 2.0 nm/sec.

13. A method according to one of the claims from 1 to 6, wherein, for obtaining a compact and homogeneous layer having a thickness lower than or equal to 1.0 µm, the evaporation-deposition step comprises a first and a second step of growth, in each of which the deposition rate is maintained constant for a predetermined time ranging between 10 and 15 minutes; and wherein the deposition rate is constant in the range between 0.01 and 0.03 nm/sec in the first step of growth; and is constant in the range between 2.0 and 2.5 nm/sec in the second step of growth.

14. A method according to one of the claims from 11 to 13, wherein the first step of growth has a deposition rate no lower than 0.03 nm/sec.

15. A method according to one of the preceding claims, wherein the evaporation-deposition step comprises, between two successive steps of growth, a step of re-establishment of the target, in which the target is supplied with mixed oxide.

16. A method according to one of the preceding claims, wherein the substrate is made of a composite material metal/oxide, oxide1/oxide2, or one of the latter already covered with an electrolytic layer for SOFCs.

17. A method according to one of the preceding claims, comprising an *in situ* heat treatment and annealing step of the film of mixed oxide, carried out in the same deposition chamber in which the electron beam is sent onto the target for evaporating material that deposits on the substrate; and in which heat treatment and annealing step the film of mixed oxide deposited on the substrate in the evaporation-deposition step is heat treated and annealed in inert atmosphere or in oxidizing atmosphere.

18. A method according to claim 17, wherein the *in situ* heat treatment and annealing step of the film of mixed oxide comprises the steps of: bringing the temperature of the pre-treated substrate to a temperature in the range between 500°C and 800°C, while introducing into the deposition chamber, at least in the vicinity of the substrate, a gas flow, until reaching in the deposition chamber a partial pressure in the range between 200 mbar and 1000 mbar; and then maintaining constant pressure and temperature in the deposition chamber for a time in the range between 30 and 60 minutes.

19. A method according to one of the preceding claims, wherein the mixed oxide is selected in the group consisting of: BaCe_{0.9}Y_{0.1}O_{3-d} (BCY-10), BaCe₀.₈Y₀.₂O_{3-d} (BCY-20), (La_{0.8}Sr_{0.2}) ₀.₉₅CoO_{3-d} (LSC), (Y₂O₃)_{0.08} (ZrO₂)₀.₉₂ (8-YSZ), Gd₀.₁Ce₀.₉O_{2-d} (10-GDC), Gd₀.₂Ce_{0.8}O_{2-d} (20-GDC), Sm_{0.15}Ce_{0.85}O_{2-d} (15-SDC), Sm_{0.2}Ce_{0.8}O_{2-d} (20-SDC), (S_{C2}O₃)₀.₁(ZrO₂)₀.₉ (10-ScSZ), Ba (CeₓZr₁₋ₓ) ₀.₉Y_{0.1}O_{3-d} (BZY-10), Ba₂In_{1.8}Ti_{0.2}O_{5+d} (BIT-02), BaIn₀.₃Ti₀.₇O_{3-d} (BIT-07), Nd₂NiO_{4+δ}, Pr₂NiO_{4+δ}, Er_{0.4}Bi_{1.6}O₃ (ESB), Dy₀.₀₈W₀.₀₄Bi₀.₈₈O₁.₅₆ (DWSB).

20. A method according to one of the preceding claims, wherein the film of mixed oxide is an electrolytic or cathodic thin layer of a SOFC, and the substrate is a composite anodic substrate of said SOFC.

## Patentansprüche

1. Verfahren zur Abscheidung einer Schicht eines gemischten Oxids auf einem Verbundstoffsubstrat, umfassend einen Schritt des Verdampfens und Abscheidens eines gemischten Oxids, bei dem ein Elektronenstrahl auf ein Target aus einem gemischten Oxid mit derselben stöchiometrischen Zusammensetzung wie die abzuscheidende Schicht geleitet wird, so dass eine Verdampfung von Material vom Target und Abscheidung des verdampften Materials auf einem aus einem Verbundstoff bestehenden Substrat bewirkt wird, wobei das Verfahren **dadurch gekennzeichnet ist, dass** der Schritt des Verdampfens und Abscheidens mit einer auf dem Substrat gemessenen Abscheidungsgeschwindigkeit durchgeführt wird, die sich während des Schritts des Verdampfens und Abscheidens erhöht.

2. Verfahren gemäß Anspruch 1, wobei der Schritt des Verdampfens und Abscheidens wenigstens einen ersten Wachstumsschritt, der mit einer Abscheidungsgeschwindigkeit durchgeführt wird, die kleiner oder gleich einer vorbestimmten Schwelle ist, und wenigstens einen zweiten Wachstumsschritt, der mit einer Abscheidungsgeschwindigkeit durchgeführt wird, die größer als die Schwelle ist, umfasst, wobei die Schwelle insbesondere 0,03 nm/s beträgt.

3. Verfahren gemäß Anspruch 1 oder 2, wobei der Schritt des Verdampfens und Abscheidens zwei oder mehr Wachstumsschritte, bei denen die Abscheidungsgeschwindigkeit konstant ist, umfasst und die Abscheidungsgeschwindigkeit von wenigstens einem Wachstumsschritt zum nächsten zunimmt.

4. Verfahren gemäß einem der vorstehenden Ansprüche, wobei der Schritt des Verdampfens und Abscheidens wenigstens einen Wachstumsschritt umfasst, bei dem die Abscheidungsgeschwindigkeit allmählich zunimmt.

5. Verfahren gemäß einem der vorstehenden Ansprüche, wobei die Abscheidungsgeschwindigkeit in jedem Wachstumsschritt konstant gehalten wird oder zunimmt, gegebenenfalls in jeweiligen Wachstumsschritten in unterschiedlicher Weise zunimmt.

6. Verfahren gemäß einem der vorstehenden Ansprüche, umfassend einen Schritt des Auswählens der notwendigen Anzahl von Wachstumsschritten als Funktion der gewünschten endgültigen Dicke der Schicht des gemischten Oxids.

7. Verfahren gemäß einem der Ansprüche 1 bis 6, wobei der Schritt des Verdampfens und Abscheidens, um auf dem Substrat eine kompakte und homogene Schicht aus gemischtem Oxid mit einer Dicke von mehr als 1,5 µm zu erhalten, wenigstens vier Wachstumsschritte umfasst, in denen jeweils die Abscheidungsgeschwindigkeit während einer vorbestimmten Zeit im Bereich zwischen 60 und 90 Minuten konstant gehalten wird, und wobei die Abscheidungsgeschwindigkeit in jedem Wachstumsschritt größer oder gleich der Abscheidungsgeschwindigkeit im vorherigen Wachstumsschritt und kleiner oder gleich der Abscheidungsgeschwindigkeit im folgenden Wachstumsschritt ist und die Abscheidungsgeschwindigkeit zwischen wenigstens einem Wachstumsschritt und dem nächsten zunimmt.

8. Verfahren gemäß Anspruch 7, wobei der Schritt des Verdampfens und Abscheidens umfasst:
- einen ersten Wachstumsschritt mit einer Abscheidungsgeschwindigkeit, die im Bereich zwischen 0,01 und 0,03 nm/s konstant ist;
- einen zweiten Wachstumsschritt mit einer Abscheidungsgeschwindigkeit, die im Bereich zwischen 0,01 und 0,03 nm/s konstant ist;
- einen dritten Wachstumsschritt mit einer Abscheidungsgeschwindigkeit, die im Bereich zwischen 0,04 und 0,06 nm/s konstant ist;
- einen vierten Wachstumsschritt mit einer Abscheidungsgeschwindigkeit, die im Bereich zwischen 0,09 und 0,11 nm/s konstant ist.

9. Verfahren gemäß einem der Ansprüche 1 bis 6, wobei der Schritt des Verdampfens und Abscheidens, um auf dem Substrat eine kompakte und homogene Schicht aus gemischtem Oxid mit einer Dicke von kleiner oder gleich 1,0 µm zu erhalten, einen ersten und einen zweiten Wachstumsschritt umfasst, in denen jeweils die Abscheidungsgeschwindigkeit während einer vorbestimmten Zeit im Bereich zwischen 60 und 90 Minuten konstant gehalten wird, und wobei die Abscheidungsgeschwindigkeit im ersten Wachstumsschritt im Bereich zwischen 0,01 und 0,03 nm/s konstant ist und im zweiten Wachstumsschritt im Bereich zwischen 0,09 und 0,15 nm/s konstant ist.

10. Verfahren gemäß einem der Ansprüche 7 bis 9, wobei der erste Wachstumsschritt mit einer Abscheidungsgeschwindigkeit von nicht weniger als 0,01 nm/s durchgeführt wird.

11. Verfahren gemäß einem der Ansprüche 1 bis 6, wobei der Schritt des Verdampfens und Abscheidens, um auf dem Substrat eine kompakte und homogene Schicht aus gemischtem Oxid mit einer Dicke von mehr als 1,5 µm zu erhalten, vier Wachstumsschritte umfasst, in denen jeweils die Verdampfungs-Abscheidungs-Geschwindigkeit während einer vorbestimmten Zeit im Bereich zwischen 10 und 15 Minuten konstant gehalten wird, und wobei die Abscheidungsgeschwindigkeit in jedem Wachstumsschritt größer oder gleich der Abscheidungsgeschwindigkeit im vorherigen Wachstumsschritt und kleiner oder gleich der Abscheidungsgeschwindigkeit im folgenden Wachstumsschritt ist und die Abscheidungsgeschwindigkeit zwischen wenigstens einem Wachstumsschritt und dem nächsten zunimmt.

12. Verfahren gemäß Anspruch 11, wobei der Schritt des Verdampfens und Abscheidens umfasst:
- einen ersten Wachstumsschritt mit einer Abscheidungsgeschwindigkeit, die im Bereich zwischen 0,01 und 0,03 nm/s konstant ist;
- einen zweiten Wachstumsschritt mit einer Abscheidungsgeschwindigkeit, die im Bereich zwischen 0,2 und 0,4 nm/s konstant ist;
- einen dritten Wachstumsschritt mit einer Abscheidungsgeschwindigkeit, die im Bereich zwischen 0,7 und 1,0 nm/s konstant ist;
- einen vierten Wachstumsschritt mit einer Abscheidungsgeschwindigkeit, die im Bereich zwischen 1,6 und 2,0 nm/s konstant ist.

13. Verfahren gemäß einem der Ansprüche 1 bis 6, wobei der Schritt des Verdampfens und Abscheidens, um auf dem Substrat eine kompakte und homogene Schicht aus gemischtem Oxid mit einer Dicke von kleiner oder gleich 1,0 µm zu erhalten, einen ersten und einen zweiten Wachstumsschritt umfasst, in denen jeweils die Abscheidungsgeschwindigkeit während einer vorbestimmten Zeit im Bereich zwischen 10 und 15 Minuten konstant gehalten wird, und wobei die Abscheidungsgeschwindigkeit im ersten Wachstumsschritt im Bereich zwischen 0,01 und 0,03 nm/s konstant ist und im zweiten Wachstumsschritt im Bereich zwischen 2,0 und 2,5 nm/s konstant ist.

14. Verfahren gemäß einem der Ansprüche 11 bis 13, wobei der erste Wachstumsschritt eine Abscheidungsgeschwindigkeit von nicht weniger als 0,03 nm/s aufweist.

15. Verfahren gemäß einem der vorstehenden Ansprüche, wobei der Schritt des Verdampfens und Abscheidens zwischen zwei aufeinanderfolgenden Wachstumsschritten einen Schritt der Erneuerung des Targets umfasst, in dem das Target mit gemischtem Oxid versorgt wird.

16. Verfahren gemäß einem der vorstehenden Ansprüche, wobei das Substrat aus einem Metall/Oxid-Verbundstoff, einem Oxid1/Oxid2-Verbundstoff oder einem der letzteren, der bereits mit einer elektrolytischen Schicht für Festoxidbrennstoffzellen bedeckt ist, besteht.

17. Verfahren gemäß einem der vorstehenden Ansprüche, das einen Schritt der in-situ-Wärmebehandlung und des Temperns der Schicht des gemischten Oxids umfasst, der in derselben Abscheidungskammer durchgeführt wird, in der der Elektronenstrahl auf das Target geleitet wird, um Material zu verdampfen, das sich auf dem Substrat abscheidet, und wobei die Schicht des gemischten Oxids, die im Schritt des Verdampfens und Abscheidens auf dem Substrat abgeschieden wurde, in dem Schritt der Wärmebehandlung und des Temperns in einer inerten Atmosphäre oder in einer oxidierenden Atmosphäre wärmebehandelt und getempert wird.

18. Verfahren gemäß Anspruch 17, wobei der Schritt der in-situ-Wärmebehandlung und des Temperns der Schicht des gemischten Oxids die folgenden Schritte umfasst: Bringen der Temperatur des vorbehandelten Substrats auf eine Temperatur im Bereich zwischen 500 °C und 800 °C, während wenigstens in der Nähe des Substrats ein Gasstrom in die Abscheidungskammer eingeleitet wird, bis in der Abscheidungskammer ein Partialdruck im Bereich zwischen 200 mbar und 1000 mbar erreicht ist, und dann Aufrechterhalten eines konstanten Drucks und einer konstanten Temperatur in der Abscheidungskammer während einer Zeit im Bereich zwischen 30 und 60 Minuten.

19. Verfahren gemäß einem der vorstehenden Ansprüche, wobei das gemischte Oxid aus der Gruppe ausgewählt ist, die aus BaCe_{0,9}Y_{0,1}O_{3-d} (BCY-10), BaCe_{0,8}Y_{0,2}O_{3-d} (BCY-20), (La_{0,8}Sr_{0,2})_{0,95}CoO_{3-d} (LSC), (Y₂O₃)_{0,08}(ZrO₂)_{0,92} (8-YSZ), Gd_{0,1}Ce_{0,9}O_{2-d} (10-GDC), Gd_{0,2}Ce_{0,8}O_{2-d} (20-GDC), Sm_{0,15}Ce_{0,85}O_{2-d} (15-SDC), Sm_{0,2}Ce_{0,8}O_{2-d} (20-SDC), (Sc₂O₃)_{0,1}(ZrO₂)_{0,9} (10-ScSZ), Ba(CeₓZr₁₋ₓ)_{0,9}Y_{0,1}O_{3-d} (BZY-10), Ba₂In_{1,8}Ti_{0,2}O_{5+d} (BIT-02), BaIn_{0,3}Ti_{0,7}O_{3-d} (BIT-07), Nd₂NiO_{4+δ}, Pr₂NiO₄₊ₛ, Er_{0,4}Bi_{1,6}O₃ (ESB), Dy_{0,08}W_{0,04}Bi_{0,88}O₁,₅₆ (DWSB) besteht.

20. Verfahren gemäß einem der vorstehenden Ansprüche, wobei die Schicht des gemischten Oxids eine elektrolytische oder kathodische Dünnschicht einer Festoxidbrennstoffzelle ist und das Substrat ein anodisches Verbundsubstrat der Festoxidbrennstoffzelle ist.

## Revendications

1. Procédé de dépôt d'un film d'oxyde mixte sur un substrat en matériau composite, comprenant une étape de dépôt par évaporation d'un oxyde mixte, dans laquelle un faisceau d'électrons est envoyé sur une cible d'oxyde mixte ayant la même composition stoechiométrique que le film à déposer, de façon à provoquer une évaporation de matériau depuis la cible et un dépôt de matériau évaporé sur un substrat réalisé en matériau composite ; le procédé étant **caractérisé en ce que** l'étape de dépôt par évaporation est réalisée avec une vitesse de dépôt, mesurée sur le substrat, qui augmente pendant ladite étape de dépôt par évaporation.

2. Procédé selon la revendication 1, dans lequel ladite étape de dépôt par évaporation comprend au moins une première étape de croissance réalisée avec une vitesse de dépôt inférieure ou égale à un seuil prédéterminé, et au moins une deuxième étape de croissance réalisée avec une vitesse de dépôt supérieure audit seuil, ledit seuil étant en particulier de 0,03 nm/s.

3. Procédé selon la revendication 1 ou 2, dans lequel l'étape de dépôt par évaporation comprend deux étapes ou plus de croissance dans lesquelles la vitesse de dépôt est constante, et la vitesse de dépôt augmente d'au moins une étape de croissance à la suivante.

4. Procédé selon l'une des revendications précédentes, dans lequel l'étape de dépôt par évaporation comprend au moins une étape de croissance dans laquelle la vitesse de dépôt augmente progressivement.

5. Procédé selon l'une des revendications précédentes, dans lequel à chaque étape de croissance, la vitesse de dépôt est maintenue constante, ou augmente, augmentant facultativement de manière différente dans des étapes de croissance respectives.

6. Procédé selon l'une des revendications précédentes, comprenant une étape de sélection du nombre nécessaire d'étapes de croissance en fonction de l'épaisseur finale souhaitée du film d'oxyde mixte.

7. Procédé selon l'une des revendications 1 à 6, dans lequel, pour l'obtention sur le substrat d'un film compact et homogène d'oxyde mixte ayant une épaisseur supérieure à 1,5 µm, l'étape de dépôt par évaporation comprend au moins quatre étapes de croissance, dans chacune desquelles la vitesse de dépôt est maintenue constante pendant une durée prédéterminée allant de 60 à 90 minutes ; et dans lequel la vitesse de dépôt dans chaque étape de croissance est supérieure ou égale à la vitesse de dépôt dans l'étape de croissance précédente et inférieure ou égale à la vitesse de dépôt dans l'étape de croissance suivante, et la vitesse de dépôt augmente entre au moins une étape de croissance et la suivante.

8. Procédé selon la revendication 7, dans lequel l'étape de dépôt par évaporation comprend :
- une première étape de croissance avec une vitesse de dépôt constante dans la plage entre 0,01 et 0,03 nm/s ;
- une deuxième étape de croissance avec une vitesse de dépôt constante dans la plage entre 0,01 et 0,03 nm/s ;
- une troisième étape de croissance avec une vitesse de dépôt constante dans la plage entre 0,04 et 0,06 nm/s ;
- une quatrième étape de croissance avec une vitesse de dépôt constante dans la plage entre 0,09 et 0,11 nm/s.

9. Procédé selon l'une des revendications 1 à 6, dans lequel, pour l'obtention sur le substrat d'un film compact et homogène d'oxyde mixte ayant une épaisseur inférieure ou égale à 1,0 µm, l'étape de dépôt par évaporation comprend une première et une deuxième étape de croissance, dans chacune desquelles la vitesse de dépôt est maintenue constante pendant une durée prédéterminée allant de 60 à 90 minutes ; et dans lequel la vitesse de dépôt est constante dans la plage entre 0,01 et 0,03 nm/s dans la première étape de croissance ; et est constante dans la plage entre 0,09 et 0,15 nm/s dans la deuxième étape de croissance.

10. Procédé selon l'une des revendications 7 à 9, dans lequel la première étape de croissance est réalisée avec une vitesse de dépôt non inférieure à 0,01 nm/s.

11. Procédé selon l'une des revendications 1 à 6, dans lequel, pour l'obtention sur le substrat d'un film compact et homogène d'oxyde mixte ayant une épaisseur supérieure à 1,5 µm, l'étape de dépôt par évaporation comprend quatre étapes de croissance, dans chacune desquelles la vitesse de dépôt par évaporation est maintenue constante pendant une durée prédéterminée allant de 10 à 15 minutes ; et dans lequel la vitesse de dépôt dans chaque étape de croissance est supérieure ou égale à la vitesse de dépôt dans l'étape de croissance précédente et inférieure ou égale à la vitesse de dépôt dans l'étape de croissance suivante ; et la vitesse de dépôt augmente entre au moins une étape de croissance et la suivante.

12. Procédé selon la revendication 11, dans lequel l'étape de dépôt par évaporation comprend :
- une première étape de croissance avec une vitesse de dépôt constante dans la plage entre 0,01 et 0,03 nm/s ;
- une deuxième étape de croissance avec une vitesse de dépôt constante dans la plage entre 0,2 et 0,4 nm/s ;
- une troisième étape de croissance avec une vitesse de dépôt constante dans la plage entre 0,7 et 1,0 nm/s ;
- une quatrième étape de croissance avec une vitesse de dépôt constante dans la plage entre 1,6 et 2,0 nm/s.

13. Procédé selon l'une des revendications 1 à 6, dans lequel, pour l'obtention d'une couche compacte et homogène ayant une épaisseur inférieure ou égale à 1,0 µm, l'étape de dépôt par évaporation comprend une première et une deuxième étape de croissance, dans chacune desquelles la vitesse de dépôt est maintenue constante pendant une durée prédéterminée allant de 10 à 15 minutes ; et dans lequel la vitesse de dépôt est constante dans la plage entre 0,01 et 0,03 nm/s dans la première étape de croissance ; et est constante dans la plage entre 2,0 et 2,5 nm/s dans la deuxième étape de croissance.

14. Procédé selon l'une des revendications 11 à 13, dans lequel la première étape de croissance a une vitesse de dépôt non inférieure à 0,03 nm/s.

15. Procédé selon l'une des revendications précédentes, dans lequel l'étape de dépôt par évaporation comprend, entre deux étapes de croissance successives, une étape de rétablissement de la cible, dans laquelle la cible est alimentée en oxyde mixte.

16. Procédé selon l'une des revendications précédentes, dans lequel le substrat est réalisé en un matériau composite métal/oxyde, oxyde 1/oxyde 2, ou l'un de ces derniers déjà couverts d'une couche électrolytique pour des SOFC.

17. Procédé selon l'une des revendications précédentes, comprenant une étape de traitement thermique et de recuit *in situ* du film d'oxyde mixte, réalisée dans la même chambre de dépôt que celle où le faisceau d'électrons est envoyé sur la cible pour évaporer le matériau qui se dépose sur le substrat ; et dans laquelle étape de traitement thermique et de recuit, le film d'oxyde mixte déposé sur le substrat dans l'étape de dépôt par évaporation est traité thermiquement et recuit dans une atmosphère inerte ou dans une atmosphère oxydante.

18. Procédé selon la revendication 17, dans lequel l'étape de traitement thermique et de recuit *in situ* du film d'oxyde mixte comprend les étapes : d'amenée de la température du substrat prétraité à une température dans la plage entre 500 °C et 800 °C, tout en introduisant dans la chambre de dépôt, au moins à proximité du substrat, un écoulement de gaz, jusqu'à atteindre dans la chambre de dépôt une pression partielle dans la plage entre 200 mbar et 1 000 mbar ; puis de maintien d'une pression et d'une température constantes dans la chambre de dépôt pendant une durée dans la plage entre 30 et 60 minutes.

19. Procédé selon l'une des revendications précédentes, dans lequel l'oxyde mixte est choisi dans le groupe constitué de : BaCe_{0,9}Y_{0,1}O_{3-d} (BCY-10), BaCe_{0,8}Y_{0,2}O_{3-d} (BCY-20), (La_{0,8}Sr₀,₂)_{0,95}CoO_{3-d} (LSC), (Y₂O₃)_{0,08} (ZrO₂)_{0,92} (8-YSZ), Gd_{0,1}Ce_{0,9}O_{2-d} (10-GDC), Gd_{0,2}Ce_{0,8}O_{2-d} (20-GDC), Sm_{0,15}Ce_{0,85}O_{2-d} (15-SDC), Sm_{0,2}Ce_{0,8}O_{2-d} (20-SDC), (Sc₂O₃)_{0,1} (ZrO₂)_{0,9} (10-ScSZ), Ba (Cexrn-x o,9Yo,i03-d (BZY-10), Ba₂In_{1,8}Ti_{0,2}O_{5+d} (BIT-02), BaIn_{0,3}Ti_{0,7}O_{3-d} (BIT-07), Nd₂NiO_{4+δ}, Pr₂NiO_{4+δ}, Er_{0,4}Bi_{1,6}O₃ (ESB), Dy_{0,08}W_{0,04}Bi_{0,88}O_{1,56} (DWSB).

20. Procédé selon l'une des revendications précédentes, dans lequel le film d'oxyde mixte est une couche mince électrolytique ou cathodique d'une SOFC, et le substrat est un substrat anodique composite de ladite SOFC.
